(19) Europäisches Patentamt
European Patent Office
Office européen des brevets

(11) **EP 1 793 279 A2**

(12) **EUROPEAN PATENT APPLICATION**

(43) Date of publication:
06.06.2007 Bulletin 2007/23

(51) Int Cl.:
*G03F 7/20* $^{(2006.01)}$    *G03F 1/00* $^{(2006.01)}$

(21) Application number: 06256105.5

(22) Date of filing: 29.11.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 30.11.2005 US 289626

(71) Applicant: ASML Netherlands BV
5504 DR Veldhoven (NL)

(72) Inventors:
• Chen, Alek Chi-Heng
Xindian City, Taipei County (TW)
• Hansen, Steven George
Phoenix, AZ 85048 (US)

(74) Representative: Leeming, John Gerard
J.A. Kemp & Co.,
14 South Square,
Gray's Inn
London WC1R 5JJ (GB)

(54) **Lithographic apparatus and device manufacturing method**

(57) A method of configuring a transfer of an image of a pattern onto a substrate with a lithographic apparatus is presented. The method includes selecting a plurality of parameters including a pupil filter parameter; calculating an image of the pattern for the selected parameters; calculating a metric that represents a variation of an attribute of the calculated image over a process range; and adjusting the plurality of parameters based on a result of the metric.

700 — Start

705 — Selecting a plurality of parameters including a pupil filter parameter

710 — Calculating an image of a pattern for the selected parameters

Calculating a metric that represents variation of one attribute of the calculated image over an assumed range of focus, dose and patterning device error

715

720 — Is the metric result within an acceptable range of variation of the attribute and/or has converged to its optimal value?    No

Yes

725 — End

Fig. 7

EP 1 793 279 A2

**Description**

This invention relates to a lithographic apparatus and a lithographic method.

A lithographic apparatus is a machine that applies a desired pattern onto a target portion of a substrate. Lithographic apparatus can be used, for example, in the manufacture of integrated circuits (ICs). In that circumstance, a beam of radiation traverses an illumination system and illuminates a patterning device. The patterning device is alternatively referred to as a mask or a reticle, and may be used to generate a circuit pattern corresponding to an individual layer of the IC. This pattern can be imaged onto a target portion (e.g., including part of, one or several dies) on a substrate (e.g., a silicon wafer) that has a layer of radiation-sensitive material (resist). In general, a single substrate will contain a network of adjacent target portions that are successively exposed. Conventional lithographic apparatus include so-called steppers, in which each target portion is irradiated by exposing an entire pattern onto the target portion at once, and so-called scanners, in which each target portion is irradiated by scanning the pattern through the beam of radiation in a given direction (the "scanning"-direction) while synchronously scanning the substrate parallel or anti-parallel to this direction.

The radiation beam upstream of the patterning device is shaped and controlled such that at a pupil plane of the illumination system the beam has a desired spatial intensity distribution. The latter distribution is referred to as an illumination mode, illumination shape or illumination arrangement. Various illumination shapes can be used. For example, traditionally, a so-called "conventional illumination" (a top-hat intensity distribution in the pupil and centered on the axis of the pupil plane) is used. Presently, also "off-axis" illumination modes such as annular, dipole, quadrupole and more complex shaped arrangements of the illumination shape are generally in use. A radial position in an illumination system pupil plane is commonly expressed as a fraction sigma (σ) of a pupil-radius which corresponds to the numerical aperture of the projection system. A conventional illumination mode may be characterized by a single value of σ, where 0 < σ < 1. Conventional illumination may also be referred to as "conventional sigma illumination" and "circular illumination". An annular illumination mode may be characterized by two sigma values: σ-inner and σ-outer, respectively indicating the inner -and outer radial extent of the annular shaped intensity distribution.

Photolithography is widely recognized as one of the key steps in the manufacture of ICs and other devices and/or structures. At present, no alternative technology seems to provide the desired pattern architecture with similar accuracy, speed, and economic productivity. However, as the dimensions of features made using photolithography become smaller, photolithography is becoming one of the most, if not the most, critical gating factors for enabling miniature IC or other devices and/or structures to be manufactured on a truly massive scale.

A theoretical estimate of the limits of pattern printing can be given by the Rayleigh criterion for resolution as shown in equation (1):

$$CD = k_1 * \frac{\lambda}{NA_{PS}} \qquad (1)$$

where λ is the wavelength of the radiation used, $NA_{PS}$ is the numerical aperture of the projection system used to print the pattern, $k_1$ is a process dependent adjustment factor, also called the Rayleigh constant, and CD is the feature size of a feature arranged in an array with a 1:1 duty cycle (i.e. equal lines and spaces or holes with size equal to half the pitch) . Thus, in the context of an array of features characterized by a certain pitch at which the features are spaced in the array, the critical dimension CD in Equation (1) represents the value of half of a minimum pitch that can be printed lithographically, referred to hereinafter as the "half-pitch".

It follows from equation (1) that a reduction of the minimum printable size of features can be obtained in three ways: by shortening the exposure wavelength λ, by increasing the numerical aperture $NA_{PS}$ or by decreasing the value of $k_1$.

Current resolution enhancement techniques that have been extensively used in lithography to lower the Rayleigh constant $k_1$, thereby improving the pattern resolution, include the use of phase shift masks and off-axis illumination. These resolution enhancement techniques are of particular importance for lithographic printing and processing of contact holes or vias which define connections between wiring levels in an IC device, because contact holes have, compared to other IC features, a relatively small area. Contact holes may be printed, for example, using conventional on-axis illumination in combination with an alternating-aperture phase shift mask and a positive resist.

Alternatively, contact holes may be printed using off-axis illumination in combination with either a binary mask or an attenuated phase shift mask and a positive resist.

A binary mask is composed of quartz and chrome features. With a binary mask, the radiation passes through the clear quartz areas and is blocked by the opaque chrome areas. Attenuated phase shift masks form their patterns through adjacent areas of quartz and, for example, molybdenum silicide (MoSi). Unlike chrome, MoSi or any other equivalent material allows a small percentage of the radiation to pass through (typically 6%). However, the thickness of the MoSi is chosen so that the transmitted radiation is 180° out of phase with the radiation that passes through the neighboring clear quartz areas. The radiation that passes through the MoSi areas is too weak to expose the resist. However, the phase difference serves to "push" the intensity down to be "darker" than similar features in chrome.

Off-axis illumination improves resolution and depth of focus by allowing the first order diffracted beam and the zeroth order beam emanating from the patterning device pattern to be simultaneously captured at a higher diffraction angle, hence producing smaller pitch.

However, the use of attenuated phase shift masks or binary masks with off axis illumination may not be feasible to pattern contact holes below about 85 nm (at $\lambda$ = 193 nm, $NA_{PS}$ = 0.93, and $k_1$ = 0.4). These techniques have limited capabilities and may not provide sufficient process latitude (i.e. the combined usable depth of focus and allowable variance of exposure dose for a given tolerance in the critical dimension) for printing half-pitches below a CD obtainable when operating at $k_1$ = 0.4.

Aspects of the invention include a method of transferring an image of a mask pattern onto a substrate with a lithographic apparatus, the method including illuminating a mask pattern with a radiation beam to produce a patterned beam of radiation, the patterning device consisting of a chromeless phase shift mask or a high transmission attenuated phase shift mask having a percentage of transmission higher than about 10%; filtering the patterned beam of radiation to substantially eliminate a zeroth non diffracted order; and projecting the filtered patterned beam of radiation onto a substrate.

In another aspect of the invention, there is provided a method of configuring a transfer of an image of a mask pattern onto a substrate with a lithographic apparatus. The method includes selecting a plurality of parameters including a pupil filter parameter; calculating an image of the pattern for the selected parameters; calculating a metric that represents a variation of an attribute of the calculated image over a process range; and based on a result of the metric, iteratively (a) adjusting the pupil filter diameter, (b) calculating the image of the pattern and (c) calculating the metric until a substantially minimum or maximum value of variation of said attribute is obtained.

In a further aspect of the invention, there is provided a lithographic apparatus including an illumination system configured to condition a beam of radiation; a support structure configured to support a patterning device, the patterning device configured to pattern the beam of radiation to form a patterned beam of radiation, the patterning device consisting of a chromeless phase shift mask or a high transmission attenuated phase shift mask having a percentage of transmission higher than about 10%; a substrate table configured to hold a substrate; a projection system configured to project the patterned beam of radiation onto the substrate; and a filter arranged in a pupil plane of the projection system and configured to substantially eliminate a zeroth diffracted order of the patterned beam of radiation.

In another aspect of the invention, there is provided a computer product having machine executable instructions, the instructions being executable by a machine to perform a method of configuring a transfer of an image of a pattern onto a substrate with a lithographic apparatus, the method including selecting a plurality of parameters including a pupil filter parameter; calculating an image of the mask pattern for the selected parameters; calculating a metric that represents a variation of an attribute of the calculated image over a process range; and based on a result of the metric, iteratively (a) adjusting the pupil filter diameter, (b) calculating the image of the pattern and (c) calculating the metric until a substantially minimum or maximum value of variation of said attribute is obtained.

Embodiments of the invention will now be described, by way of example only, with reference to the accompanying schematic drawings in which corresponding reference symbols indicate corresponding parts, and in which:

FIG. 1 represents a lithographic apparatus in accordance with an embodiment of the invention;

FIG. 2(a) shows a simulated diffraction pattern resulting from the illumination of the pattern of contact holes shown in FIG. 2(b) with a conventional illumination mode having a sigma of about 0.1;

FIG. 2(b) shows a schematic pattern of 90 nm contact holes arranged in a 140 nm pitch;

FIG. 3(a) shows simulated amplitude variations of various diffraction orders as a function of contact hole size, for a binary mask;

FIG. 3(b) shows simulated variations of maximum intensity of pairs of diffraction orders as a function of contact hole size, for a binary mask;

FIG. 4(a) shows simulated amplitude variations of various diffraction orders as a function of contact hole size, for a chromeless mask;

FIG. 4(b) shows simulated variations of maximum intensity of pairs of diffraction orders as a function of contact hole size, for a chromeless mask;

FIG. 4(c) shows a top view of a chromeless mask having 100% transmitting areas of 0° shifted quartz and 100 % transmitting areas of 180° shifted quartz;

FIG. 4(d) shows a pattern of posts that results from the illumination of the chromeless mask of FIG. 4(c) with a conventional illumination including a zeroth order beam;

FIG. 5(a) shows simulated maximum exposure latitude variation as a function of pitch for various lithographic processes with and without pupil filtering;

FIG. 5(b) shows simulated depth of focus variation as a function of pitch for various lithographic processes with and without pupil filtering;

FIG. 5(c) shows simulated mask error enhancement factor (MEEF) variation as a function of pitch for various lithographic processes with and without pupil filtering;

FIG. 6 shows simulated critical dimension uniformity variation as a function of pitch for various lithographic processes with and without pupil filtering;

FIG. 7 is a flowchart of a method for configuring the optical transfer of a pattern onto a substrate in accordance with an embodiment of the invention;

FIG. 8 shows simulated CD variation half range obtained with a conventional illumination method and the method of FIG. 7;

FIG. 9 shows simulated variation of MEEF as a function of pitch for a conventional illumination method and the method of FIG. 7;

FIG. 10 shows simulated variation of focus sensitivity as a function of pitch for a conventional illumination method and the method of FIG. 7;

FIG. 11 schematically shows a random or irregular pattern of contact holes in accordance with an embodiment of the invention;

FIG. 12 shows simulated variation of exposure latitude as a function of depth of focus for the nine selected contact holes shown in FIG. 11;

FIG. 13 shows simulated variation of exposure latitude as a function of depth of focus for the nine selected contact holes shown in FIG. 11 in accordance with an embodiment of the invention;

FIG. 14 shows simulated variation of exposure latitude as a function of depth of focus for the nine selected contact holes shown in FIG. 11;

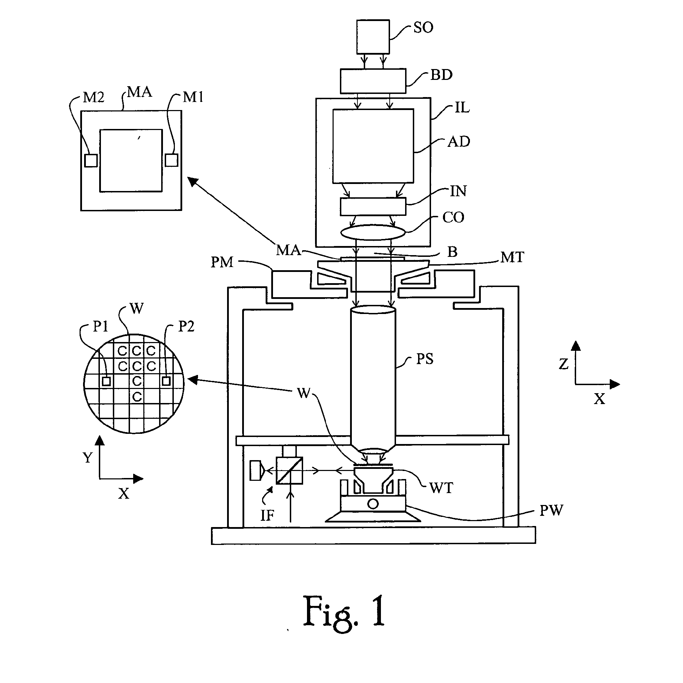

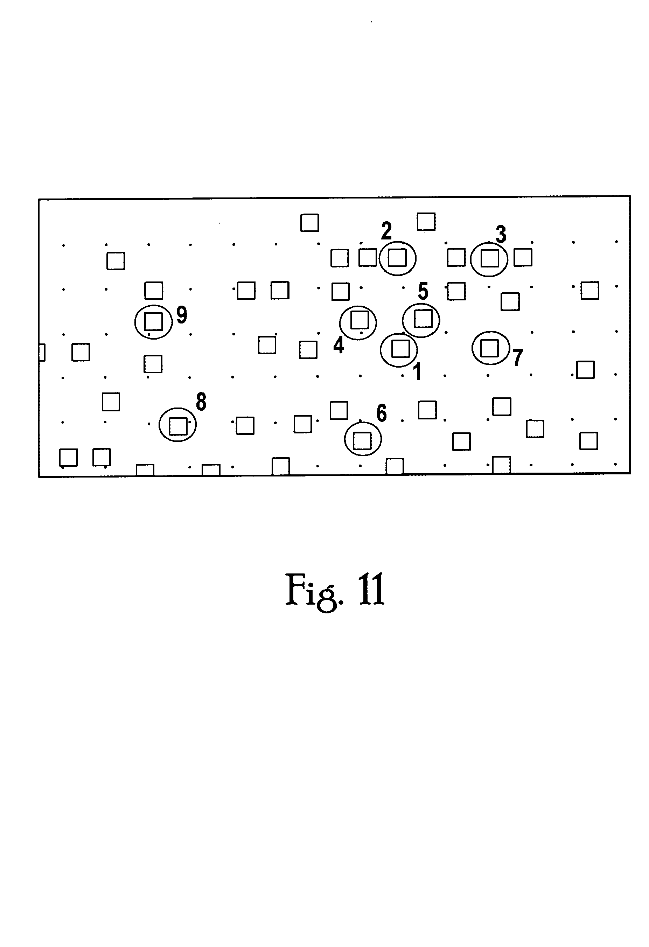

FIG. 1 5 shows simulated variation of exposure latitude as a function of depth of focus for the nine selected contact holes shown in FIG. 11 in accordance with an embodiment of the invention;

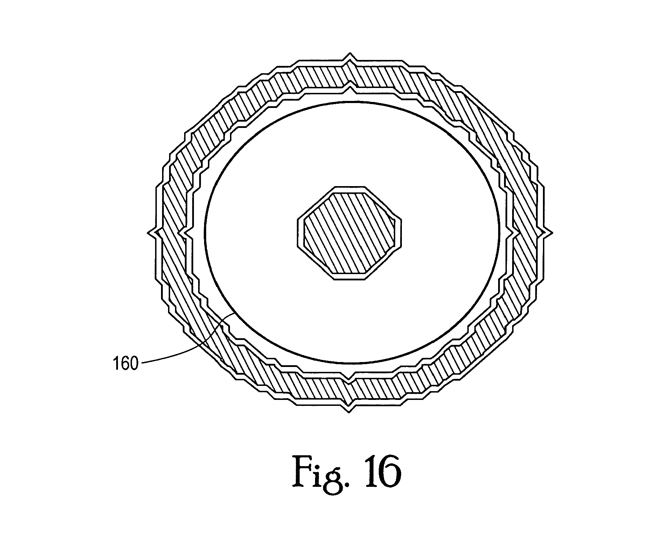

FIG. 16 shows a simulated cross section of an illumination configuration in accordance with an embodiment of the invention;

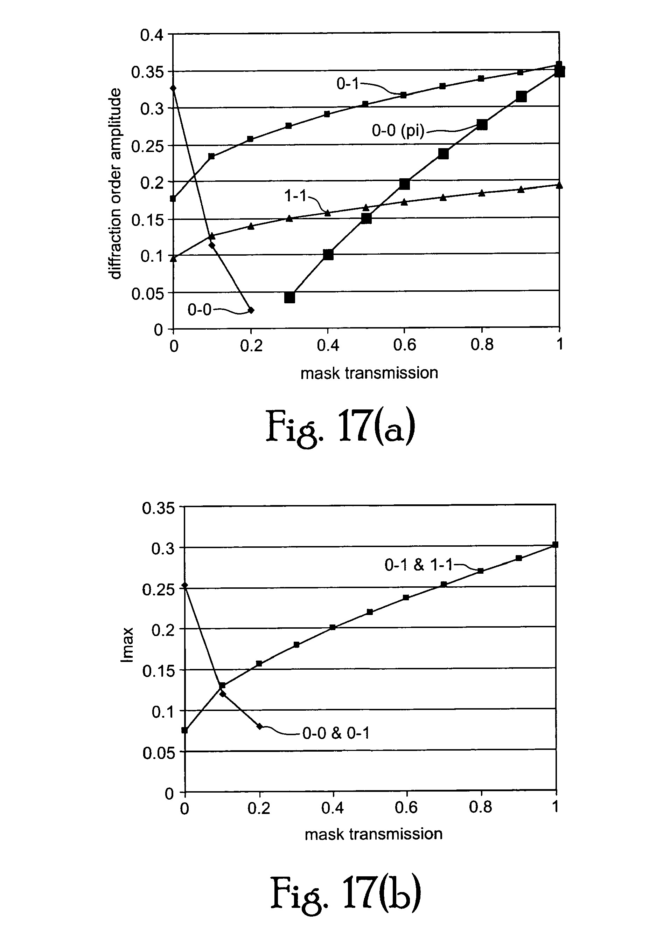

FIG. 17(a) shows simulated maximum amplitude variation of various diffraction orders (00), (01), (11) and (00 pi) as a function of mask transmission (%); and

FIG. 17(b) shows simulated maximum intensity variation of pairs of diffraction orders as a function of mask transmission (%).

FIG. 1 schematically depicts a lithographic apparatus according to an embodiment of the invention. The apparatus includes an illumination system (illuminator) IL adapted to condition a beam B of radiation (*e.g.*, UV radiation) and a support structure (*e.g.*, a mask table) MT configured to hold a patterning device (*e.g.*, a mask) MA and connected to a first positioning device PM configured to accurately position the patterning device with respect to the projection system PS. The apparatus also includes a substrate table (*e.g.*, a wafer table) WT configured to hold a substrate (*e.g.*, a resist-coated wafer) W and connected to a second positioning device PW configured to accurately position the substrate with respect to the projection system PS. The apparatus also includes a projection system (*e.g.*, a refractive projection lens) PS adapted to image a pattern imparted to the beam B by the patterning device MA onto a target portion C (*e.g.*, including one or more dies) of the substrate W.

As depicted here, the apparatus is of a transmissive type (*e.g.*, employing a transmissive mask). Alternatively, the apparatus may be of a reflective type (*e.g.*, employing a programmable mirror array of a type as referred to below).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD, including for example suitable directing mirrors and/or a beam expander. In other cases the source may be an integral part of the apparatus, for example when the source is a mercury lamp. The source SO and the illuminator IL, together with the beam delivery system BD if required, may be referred to as a radiation system.

The projection system PS may include a diaphragm with an adjustable clear aperture used to set the numerical aperture of the projection system PS at substrate level at a selected value. The maximum selectable numerical aperture or, in the case of a fixed clear aperture, the fixed numerical aperture, will be referred to as $NA_{PS}$.

At patterning device level, a corresponding angular capture range within which the projection system PS is capable of receiving rays of radiation of the beam B is given by the object-side numerical aperture of the projection system PS, referred to as $NA_{PSOB}$. The maximum object-side numerical aperture of the projection system PS is denoted by max $NA_{PSOB}$. Projection systems in optical lithography are commonly embodied as reduction projection systems with a reduction ratio M of, for example, 5x or 4x. A numerical aperture $NA_{PSOB}$ is related to $NA_{PS}$ through the reduction ratio M by $NA_{PSOB} = NA_{PS} / M$.

The beam of radiation B provided by the illumination system IL to the patterning device MA includes a plurality of rays of radiation, each having a corresponding angle of incidence on the patterning device (*e.g.*, a mask), defined with respect to axis Z in Figure 1. These rays may be characterized by an illumination numerical aperture $NA_{IL}$ in accordance with $NA_{IL} = \sin(\text{angle of incidence})$, where the index of refraction of the space at an upstream location relative to the patterning device is assumed to be 1. However, instead of characterizing an illumination ray of radiation by its $NA_{IL}$, the ray may alternatively be characterized by the radial position of the corresponding point traversed by that ray in a pupil of the illumination system. This radial position is linearly related to $NA_{IL}$, and it is common practice to define a corresponding normalized radial position σ in a pupil of the illumination system by:

$$\sigma = NA_{IL} / NA_{PSOB} \qquad\qquad (2)$$

In addition to an integrator IN and a condensor CO, the illumination system includes an adjusting device AM configured to set an outer and/or inner radial extent (commonly referred to as σ-outer and σ-inner, respectively) of the intensity distribution in the pupil of the illumination system. The maximum numerical aperture of illumination radiation is then defined by $NA_{ILmax} = \sigma\text{-outer} * NA_{PSOB}$. In view of the normalization, when σ-outer = 1, rays traversing the edge of the illumination pupil (and hence having maximum illumination numerical aperture) can just be captured (in the absence of diffraction by the patterning device MA) by the projection system PS, because then $NA_{ILmax} = NA_{PSOB}$.

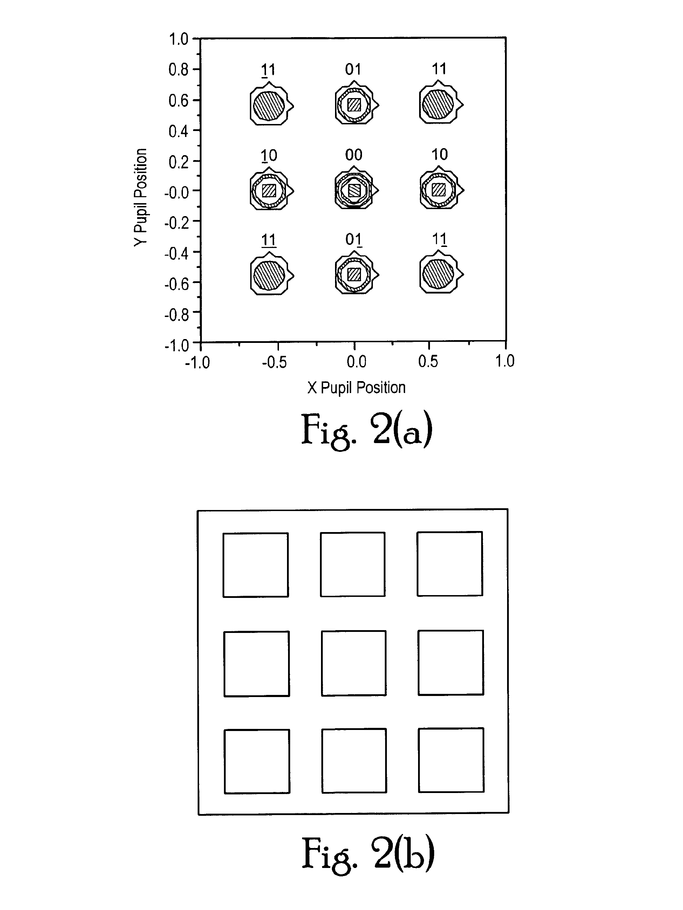

The beam of radiation B is incident on the patterning device MA, which is held on the support structure MT. Having traversed the patterning device MA, the beam of radiation B passes through the projection system PS, which focuses the beam onto a target portion C of the substrate W. With the aid of the second positioning device PW and position sensor IF (*e.g.*, an interferometric device), the substrate table WT can be moved accurately, *e.g.*, so as to position different target portions C in the path of the beam B. Similarly, the first positioning device PM and another position sensor (which is not explicitly depicted in FIG. 2) can be used to accurately position the patterning device MA with respect to the path of the beam B, *e.g.*, after mechanical retrieval from a mask library, or during a scan. In general, movement of the support structure MT and substrate table WT will be realized with the aid of a long-stroke module (coarse positioning) and a short-stroke module (fine positioning), which form part of one or both of the positioning devices PM and PW. However, in the case of a stepper (as opposed to a scanner) the support structure MT may be connected to a short stroke actuator only, or may be fixed. Patterning device MA and substrate W may be aligned using patterning device alignment marks M1, M2 and substrate alignment marks P1, P2.

The depicted apparatus may be used in the following preferred modes:

1. In step mode, the support structure MT and the substrate table WT are kept essentially stationary, while an entire pattern imparted to the beam of radiation is projected onto a target portion C at once (*i.e.,* a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the beam of radiation is projected onto a target portion C (*i.e.,* a single dynamic exposure). The velocity and direction of the substrate table WT relative to the support structure MT is determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the projection beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes a programmable patterning device, such as a programmable mirror array of a type as referred to above.

Combinations and/or variations of the above described modes of use or entirely different modes of use may also be employed.

In order to estimate the performance of a lithographic process, various parameters may be used. One of the imaging quality parameters of relevance for high resolution lithography is the mask error enhancement factor (MEEF). MEEF corresponds to the incremental change in the final feature size printed on the target substrate per unit change in the corresponding pattern feature size (where the pattern dimension is scaled to substrate size by the reduction ratio of the imaging apparatus). Near the resolution limit of a lithographic apparatus, the MEEF often rises dramatically. Additional parameters, such as the exposure latitude, depth of focus, dose to size (the amount of exposure dose energy required to produce the proper dimension of the resist feature, also referred to as "E1:1"), may also be used.

When a pattern of, *e.g.*, a mask, is illuminated with a coherent beam of radiation, it generates a diffraction pattern and the angles at which the radiation is diffracted are determined by the spatial frequency components of the pattern. For example, an infinite line/space pattern which has a single spatial frequency defined by a pitch P of the line/space pattern diffracts coherent radiation (traveling to the pattern along the optical axis) in a direction perpendicular to the lines and spaces of the pattern at angles (or diffraction orders n, where n is an integer) that are defined by the following equation (3):

$$\theta = \sin^{-1}\{(n*\lambda)/P\} \qquad\qquad (3)$$

FIG. 2(a) shows a simulated diffraction pattern resulting from the illumination of a pattern of contact holes with a conventional circular illumination shape with 0.1 sigma . The pattern of contact holes corresponds to an array of 90 nm holes arranged in a 140 nm pitch, as shown schematically in FIG. 2(b).

The diffraction pattern of FIG. 2(a) corresponds to the diffraction pattern associated with each hole of the array of FIG. 2(b) and includes the zeroth non diffracted order (00) and the first and second diffracted orders. The first diffracted orders are aligned along two substantially perpendicular axis, as viewed in FIG. 2(a), and includes positive orders (10) and (01) and negative orders (10) and (01). The second diffracted orders include positive order (11) and negative orders (11), (11) and (11). In order to capture all of these diffracted orders for visualization purposes, i.e., the first and second orders, generated by the array of contact holes of FIG. 2(b), the numerical aperture of the projection system is set to about 2.39. As such, FIG. 2(a) corresponds to a cross section of radiation beam B collected by the projection system S.

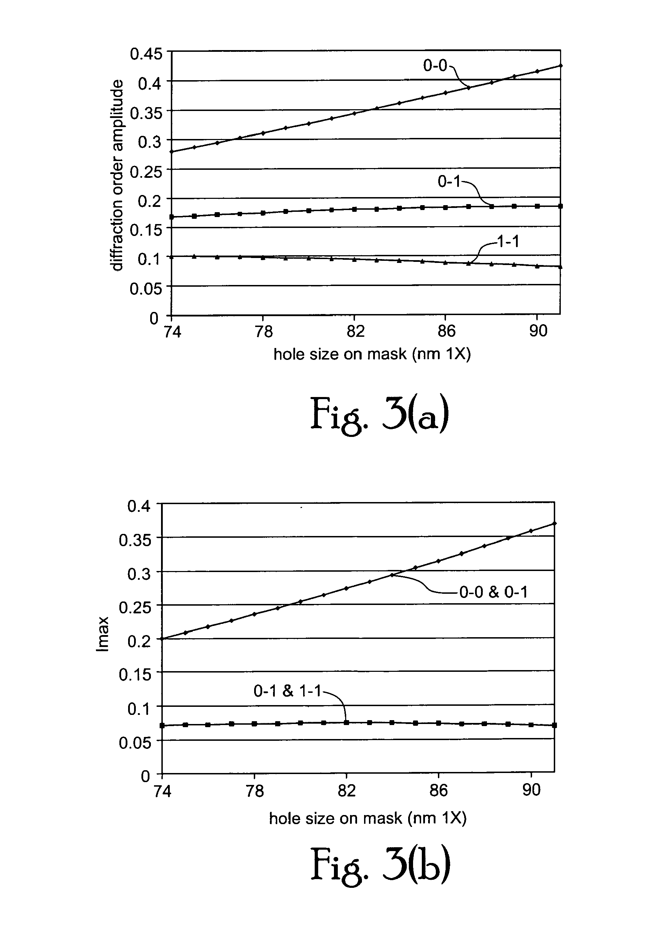

The response of the different components/orders of the radiation beam B to changes in contact hole size may substantially vary, as shown by the simulation results depicted in FIG. 3(a). This figure shows the simulated amplitude variation of selected diffraction orders ((01) and (11)) as a function of hole size on the patterning device. The calculations are performed for a square array of 75 nm contact holes arranged in a 140 nm pitch on a binary mask (BIM). The variation of the zeroth order is also represented in FIG. 3(a). For symmetry reasons, only the amplitude of diffraction orders (01) and (11) is represented, as the amplitude of orders ((10), (10) and (01)) and ((11), (11) and (11)) should remain substantially the same as that of diffraction orders (01) and (11), respectively. As such, their representation is omitted.

As can be seen in FIG. 3(a), the amplitude of the zeroth non-diffracted order rapidly increases as the hole size increases. By contrast, the responses of the first and second diffraction orders, although having a lower amplitude, remain substantially constant regardless of the hole size of the pattern. The corresponding results in terms of maximum intensity are shown in FIG. 3(b). FIG. 3(b) shows the calculated aerial image intensity for a first pair of diffraction orders, (00) and (01), and a second pair of diffraction orders, (01) and (11). The calculated aerial image intensity is defined as Imax = $(A + A')^2$, where A and A' each represent the amplitude of a diffraction order. Aerial image calculations are performed with the PROLITH™ software simulator using a scalar model. FIG. 3(b) shows that imaging with a radiation beam including the zeroth non-diffracted order (00) and the first diffracted order (01) is very sensitive to hole size, thus producing high MEEF. By contrast, imaging with a radiation beam including the first and second diffracted orders (01) and (11) is substantially insensitive to hole size, thus producing low MEEF.

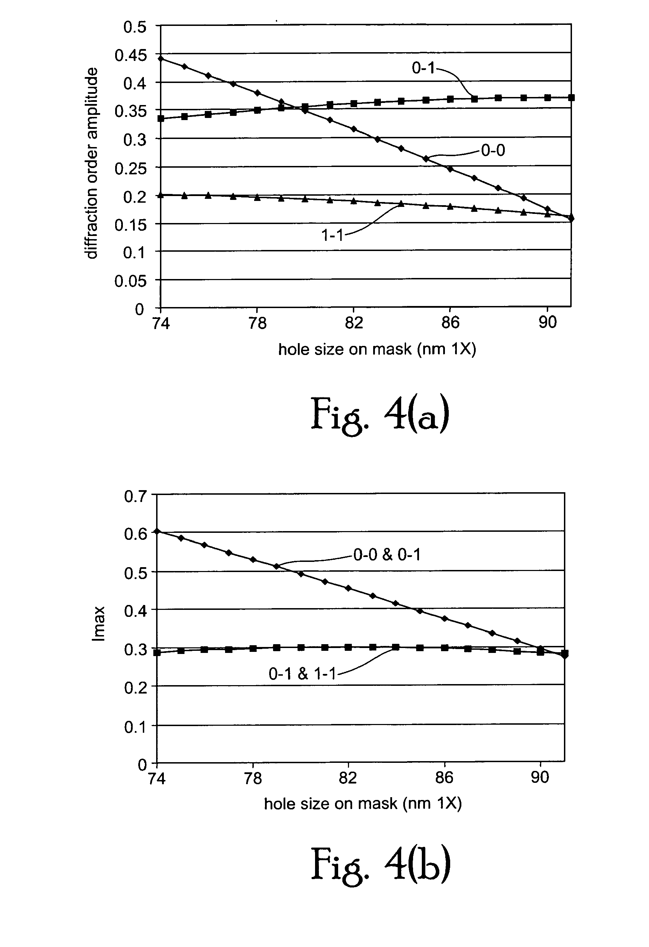

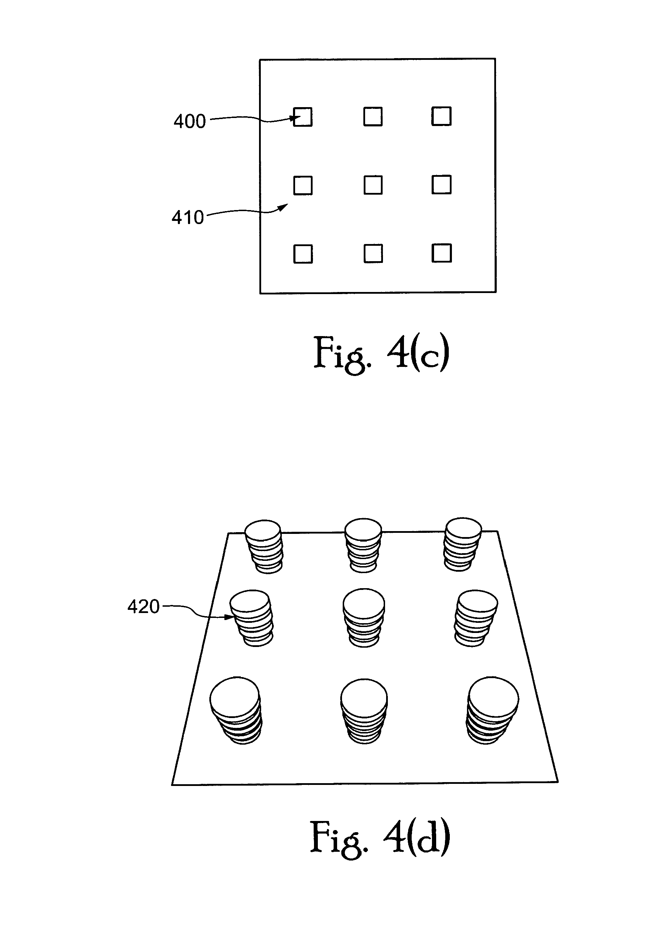

FIGS. 4(a)-(b) show similar calculations to those of FIGS. 4(a)-(b) with a chromeless mask/patterning device. A chromeless mask (or chromeless phase lithography mask, CPL mask) is a strong phase shift mask containing chrome, phase, and variable transmission (chrome and phase) features, typically including the use of scattering bars and model-based optical proximity corrections. A chromeless mask includes areas of 0° shifted quartz and 180° shifted quartz. Chromeless phase lithography stands somewhere between the space occupied by embedded attenuated phase-shift masks and the much more expensive alternating phase shift masks (alt-PSMs). AltPSMs employ alternating areas of chrome and 180° shifted quartz to form features on the wafer. AltPSM is a powerful technology. However, the process of manufacturing the mask can be considerably more demanding and expensive than that for binary masks. Furthermore, the AltPSM is accompanied by a second "Trim" mask, resulting in extra cost and decreased stepper throughput.

Referring back to FIGS. 4(a)-(b), calculations are performed for the same pattern, namely an array of 75 nm contact holes arranged in a 140 nm pitch, but with a chromeless mask. FIG. 4(a) shows the simulated variation of amplitude of various diffraction orders as a function of contact hole size, as measured on the patterning device. Similarly to FIG. 3(a), the amplitude of the zeroth non-diffracted order is very sensitive to changes in hole size. In this implementation, the phase of the zeroth non-diffracted order is opposite to that of the higher orders. As such, imaging with the zeroth non-diffracted order in a chromeless mask/patterning device produces a dark image or post rather than contact holes.

FIG. 4(c) shows a top view of a chromeless mask having 100% transmitting areas of 0° shifted quartz (400) and 100 % transmitting areas of 180° shifted quartz (410). The 100% transmitting areas of 0° shifted quartz define an array of contact holes. FIG. 4(d) shows a simulated pattern of posts 420 that result from the illumination of the chromeless mask of FIG. 4(c) with a conventional illumination mode including a zeroth order beam. Results in FIGS. 4(a)-(b) also show that the simulated amplitude and intensity of the first and second diffraction orders are significantly higher with a chromeless mask/patterning device than with a binary mask. This is of particular interest because the exposure dose can then be substantially reduced for imaging the pattern to the target size. It will also be appreciated that the intensities for zeroth and $1^{st}$ order imaging with a binary mask in FIG. 3b are similar to the intensities for $1^{st}$ and $2^{nd}$ order imaging with a chromeless mask in FIG. 4b.

In order to improve depth of focus and to reduce MEEF, it is proposed in one or more embodiments of the present invention to selectively filter diffraction orders of the radiation beam. In an embodiment of the invention, this is achieved by providing a filter or apodization plate in the projection system that at least partially blocks the zeroth non-diffracted order. In another embodiment of the invention, the filter may be configured to substantially eliminate the zeroth non-diffracted order. In yet another embodiment, the filter may be configured to further eliminate part of the first diffraction order. The apodization plate or filter may be arranged in the pupil plane of the projection system. The apodization plate or pupil filter may consist of a circular plate.

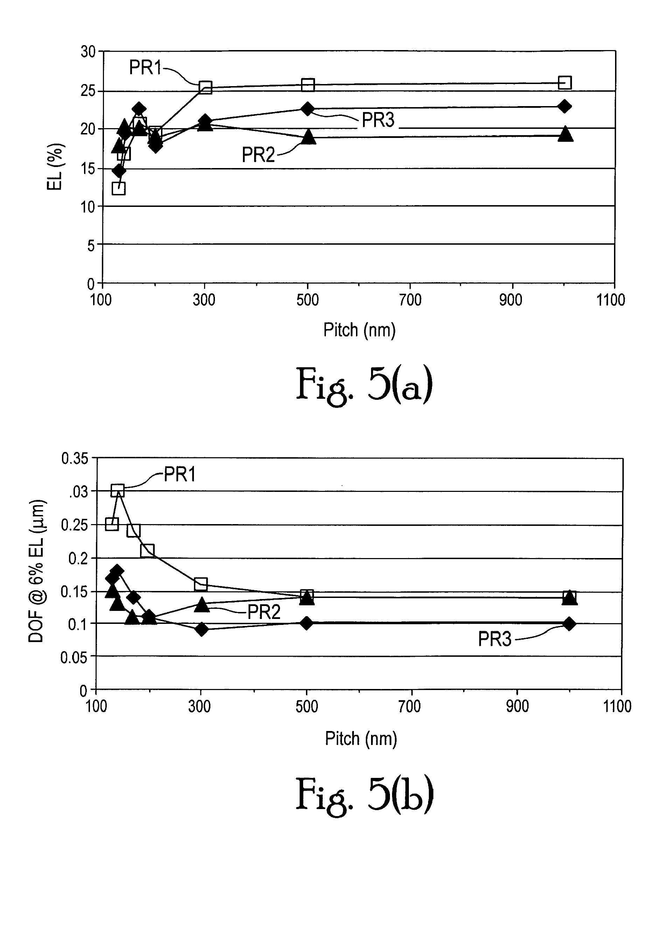

Pupil filtering may be used in conjunction with, for example, a high transmission phase shift mask (with a percentage of transmission between 10% and 100%, where 100% would be equivalent to the chromeless mask) or a binary mask. The use of a pupil filter with a binary mask may significantly increase the process window without resorting to the use of complex assist features, patterning devices or illumination configurations. FIGS. 5(a)-(c) show simulated variations of maximum exposure latitude (FIG. 5(a)), depth of focus at 6% of exposure latitude (DOF@6% EL) (FIG. 5(b)) and MEEF (FIG. 5(c)) as a function of pitch for three different lithographic processes. The first lithographic process (referred to as "0.8s & BM w PF" and identified as "PR1" in FIGS. 5(a)-(c)) includes a conventional 0.8 sigma illumination, a binary mask and a pupil filter to remove the zeroth non-diffracted order. The pupil filter consists of a 0.5 sigma plate arranged in the pupil plane of the projection system. The second lithographic process (referred to as "bullseye & ht-psm w/o PF" and identified as "PR2" in FIGS. 5(a)-(c)) includes a bullseye illumination and a 6% high transmission phase shift mask. The bullseye illumination includes a conventional 0.5 sigma illumination and an annular illumination having a 0.96/0.76 outer/inner sigma. The third process (referred to as "0.8s & ht-psm w/o PF" and identified as "PR3" in FIGS. 5(a)-(c)) combines a conventional 0.8 sigma illumination and a 6% high transmission phase shift mask. No pupil filter is provided for the second and third lithographic processes. Calculations are done with a calibrated model (PROLITH™ v 8.1) and for a pattern of 80 nm contact holes. A 1.2 numerical aperture is used. Results of FIGS. 5(a)-(c) are provided for post-OPC (i.e., after optical proximity corrections).

FIGS. 5(a)-(c) show that pupil filtering decreases MEEF while, at the same time, significantly increasing the depth of focus and the exposure latitude. The first lithographic process including pupil filtering offers the best overall lithographic performances through a 100 nm - 1000 nm pitch range, even compared to more sophisticated lithographic solutions, such as complex illuminations (e.g., bullseye illumination) and standard transmission phase shift masks.

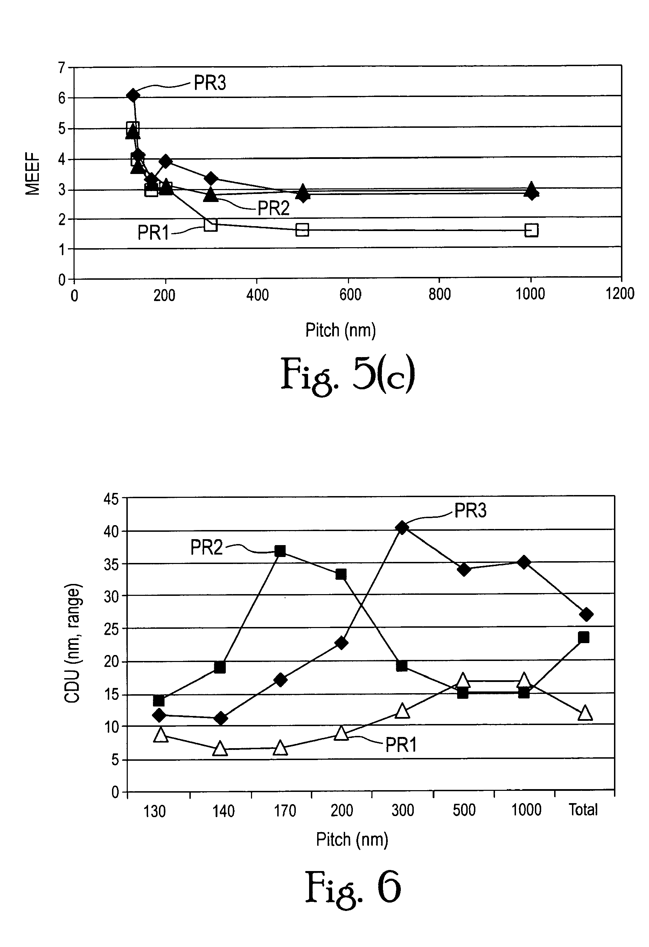

Simulated results in terms of critical dimension uniformity (CDU) are shown in FIG. 6. This figure shows the variation of CDU for a pattern of 80 nm contact holes as a function of pitch for the first, second and third lithographic processes of FIGS. 5(a)-(c) (identified in FIG. 6 as "PR1", "PR2" and "PR3" respectively). The CDU is representative of CD variations as a result of dose, focus and mask errors. This parameter substantially corresponds to the six sigma CD variation in the CD distribution. In the present case, the CDU corresponds to the quadratic sum of CD variations over an assumed, but realistic, budget of exposure dose, focus and mask errors. Specifically, calculations are done for each pitch in the 130 nm - 1000 nm range and for a 4% dose error range, a 150 nm focus error range and a 2 nm mask error range. As can be seen in FIG. 6, the first lithographic process, which combines a conventional sigma illumination and a 0.5 sigma pupil filter, provides the best results in terms of CDU. CDU values are substantially below the maximum value requirement (15 nm) through the entire pitch range.

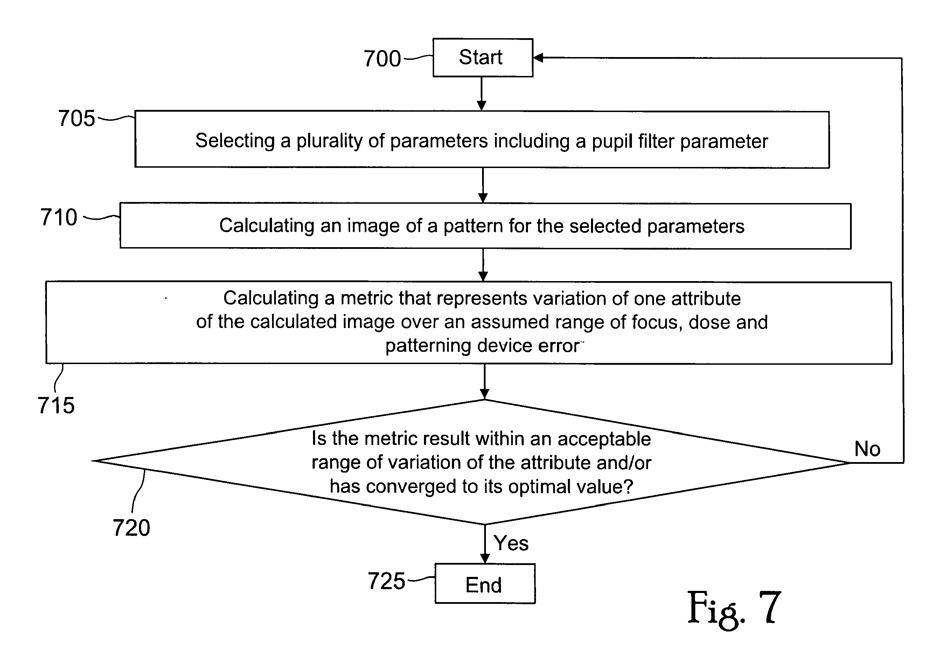

Referring now to FIG. 7, a method for configuring the optical transfer of a pattern onto a substrate in accordance with an embodiment of the invention will now be explained.

The method begins at step 700 and then proceeds to step 705, where a plurality of lithographic parameters including a pupil filter parameter are defined. In an implementation, the pupil filter parameter corresponds to the diameter of the filter plate. Alternatively, the pupil filter parameter may correspond to additional attributes of the pupil filter, such as its thickness, its absorbance, its spatial distribution of absorbance, the type of material constituting the filter or any other dimensions or characteristics of the pupil filter.

The plurality of lithographic parameters may also include illumination configuration parameters. Illumination configuration parameters that may be used in an embodiment may include the exposure dose, the numerical aperture of the illumination system, the projection system or both, and various geometric parameters that define the illumination mode, which include, more generally, the position and the dimension and spatial distribution of an illumination intensity distribution or illumination shape within the illumination system. For example, the illumination configuration parameters may include the location, the intensity, the opening angle and/or the inner/outer radius of poles of a multipole illumination shape. It will be appreciated that additional source parameters and/or other parameters may also be used in other embodiments. For example, a mask (patterning device) bias parameter may be used during the optimization procedure.

In an implementation, the lithographic parameters may also include one or more patterning device parameters, in which case, the optimization of the lithographic process in accordance with the flowchart of FIG. 7 may be referred to as an illumination configuration patterning device optimization. Example of patterning device parameters may include a size of an optical proximity correction feature embedded in the pattern to facilitate its printing. In an embodiment, the optical proximity correction feature may include a hammerhead inserted at the end of a line. Such a feature is conventionally used to prevent line shortening. In this embodiment, the dimensions of the hammerhead may be used as patterning device parameters.

After defining the lithographic parameters, the method then proceeds to step 710 where an image of the patterning device pattern is calculated for the initial set of plurality of parameters. The image of the pattern may be calculated by computer simulation.

Lithographic simulations may be performed using different models. Examples of simulation models and methods to optimize a parameterized illumination shape may be gleaned, for example, from United States Patent Application Serial No. 10/361,831, filed on February 11, 2003, entitled "Method for Optimizing an Illumination Source Using Full Resist Simulation and Process Window Metric," now United States Patent No. 6,839,125, United States Patent Application Serial No. 10/716,439, filed on November 20, 2003, and published as Pub. No. 20040158808, entitled "Lithographic Apparatus and Method for Optimizing an Illumination Source Using Isofocal Compensation," and United States Patent Application Serial No. 10/773,397, filed on February 9, 2004, and published as Pub. No. 20040156030, entitled "Lithographic Apparatus and Method for Optimizing an Illumination Source Using Photolithographic Simulations." The contents of these three applications are incorporated herein in their entirety by reference.

In an embodiment of the invention, a lithographic simulation may be performed with an aerial image model in order to determine the incident radiation energy distribution onto the radiation sensitive material (resist). Calculation of the aerial image may be done either in the scalar or vector form of the Fourier optics. Characteristics of the lithographic apparatus and process, like the numerical aperture (NA) or the specific pattern, may be entered as input parameters for the simulation. In practice, a simulation may be carried out with the aid of a commercially available simulator such as PROLITH™, SOLID-C™, LITHOCRUISER™ or the like. The quality of the aerial image may be determined by using a contrast or normalized aerial image log-slope (NILS) metric (normalized to the feature size). This value corresponds to the slope of the image intensity (or aerial image).

Relevant parameters to perform the aerial image simulation may include the distance from the focal plane of the Gaussian image plane, meaning the distance to the plane where the best plane of focus exists, as determined by geometrical ray optics, or the center wavelength of the quasi-monochromatic radiation source. The parameters may also include a measure of degree of spatial partial coherence of the illumination system, the numerical aperture of the projection system exposing the substrate, the aberrations of the optical system and a description of the spatial transmission function representing the pattern.

In another embodiment, a lithographic simulation may be performed with a resist model. In an implementation, the resist model may take into account, in the calculation of the critical dimension (or size) and its variation with variables such as dose/exposure energy and focus, the resist exposure, the resist baking and the resist developing. Likewise, the resist model may take into account, in an embodiment of the invention, a nonplanar topography and vector effects. The vector effects refer to the fact that an electromagnetic wave propagates obliquely when a high numerical aperture is used. Although vector effects can be accounted for when calculating the aerial image, a calculation of the vector effects in a low refractive index medium (*e.g.*, in air) may greatly overestimate the contrast loss obtained on the substrate because the incident rays tend to be straightened when they propagate in the resist because of the resist's higher refractive index. Therefore, a resist model with a rigorous electromagnetic calculation may be desirable to accurately estimate the actual experimental response.

Additional models like a lumped parameter model or a variable threshold resist model may also be used in other embodiments of the invention. For example, in order to provide direct, realistic results, a calibrated model may be used to calculate the image of the pattern at step 710. A calibrated model is a model that has been matched to experimental data. In an embodiment, the calibrated model may be obtained by calibrating a lithographic model of a simulator (*e.g.*, PROLITH™) with various experimental data. For example, the AutoTune option of PROLITH™ may be used to automatically calibrate the simulation model to experimental data.

Subsequent to calculating the image of the patterning device pattern, the method then proceeds to step 715 where a metric representing variation of an attribute of the simulated image is calculated over an assumed, but realistic, budget of, e.g., focus, dose and patterning device errors. In an embodiment, the attribute may correspond to the critical dimension variation (CD variation) of one of the features of the pattern. For example, the attribute may include the CD variation of the contact holes.

In an embodiment, the metric may include the square root of the quadratic sum of the CD variations induced by defocus, dose and mask variations, denoted by $CD_{total\ variation}$ and as defined in equation (4):

$$CD_{total\ variation} = \sqrt{CD_{Rfoc}^2 + CD_{Rdose}^2 + CD_{Rglobalmask}^2} \quad (4)$$

where $CD_{Rfoc}$, $CD_{Rdose}$, and $CD_{Rglobalmask}$ correspond to the CD variation induced by focus, dose, and mask variations, respectively, over an assumed budget.

It will be appreciated that the total CD variation as defined in equation (4) substantially represents the full CD variation range of the mask pattern and, as such, approximates the six sigma statistical variation range. Thus, half of the value of the CD variation (also termed as CD variation half range) substantially approximates the three sigma CD uniformity.

At step 720, a determination is made as to whether the result of the metric is acceptable, *e.g.*, within an acceptable range of variation of the attribute and, alternatively or additionally, has converged to its optimal value. For example, if the attribute corresponds to the CD variation, the range of variation may be within 10%. If the determination is positive, the method ends at step 725. If the determination is negative, the method then proceeds to step 700 where new trial conditions are generated, and the method proceeds again from step 700 to step 720 and a new value of the attribute (*e.g.*, CD variation) is obtained. In an embodiment, this procedure is iterated until a minimum value (*e.g.*, if the lithographic response is the CD variation) or a maximum value is obtained.

The new trial conditions may include, for example, new values for one or more of the lithographic parameters. Alternatively, the new trial conditions may include a new illumination arrangement (*e.g.*, shape), a new OPC, another patterning device parameter, or another illumination arrangement parameter of the previously used illumination arrangement.

The initial illumination arrangement shape (*e.g.*, conventional sigma pole, annular, dipole, quadrupole or a multipole including on and off-axis illumination) may be determined either via experimentation or simulation. In this latter case, the initial illumination shape for the selected pattern may be estimated with contour maps that are generated in accordance with the methods shown in United States Patent Application Serial No. 10/361,831, filed on February 11, 2003, entitled "Method for Optimizing an Illumination Source Using Full Resist Simulation and Process Window Metric," now United States Patent No. 6,839,125, United States Patent Application Serial No. 10/716,439, filed on November 20, 2003, and published as Pub. No. 20040158808, entitled "Lithographic Apparatus and Method for Optimizing an Illumination Source Using Isofocal Compensation," and United States Patent Application Serial No. 10/773,397, filed on February 9, 2004, and published as Pub. No. 20040156030, entitled "Lithographic Apparatus and Method for Optimizing an Illumination Source Using Photolithographic Simulations." Once the initial illumination arrangement shape is generated, a geometric parameter defining the illumination arrangement shape may be selected as one of the plurality of parameters at step 705.

In equation (4), the metric is selected to minimize CD variation. However, it will be appreciated that additional metrics and attributes may be used in other embodiments of the invention. For example, the metric may be selected to minimize MEEF or maximize the depth of focus and/or the exposure latitude.

In an embodiment of the invention, prior to calculating the metric of step 720, a subset of the parameters identified in step 705 (*e.g.*, dose, NA, illumination and patterning device parameters) may be iteratively optimized in order to print the pattern to its target size. Specifically, the calculated image of the pattern may be compared to the nominal pattern and, if the calculated image substantially differs from the nominal pattern, new values for the subset of parameters may be generated. Iterative image calculations are then performed with a convergence routine to determine the subset of parameters (*e.g.*, dose, NA, illumination and patterning device parameters) for which the nominal pattern is obtained (or is within acceptable tolerance, e.g., +-5%). Once an optimal subset is identified, the metric calculates a variation of one of the attributes of the pattern as previously explained. In an embodiment of the invention, the subset may include the pupil filter parameter.

In an embodiment, all of the plurality of parameters may be optimized prior to calculating the metric. In this implementation, the subset includes all of the plurality of parameters.

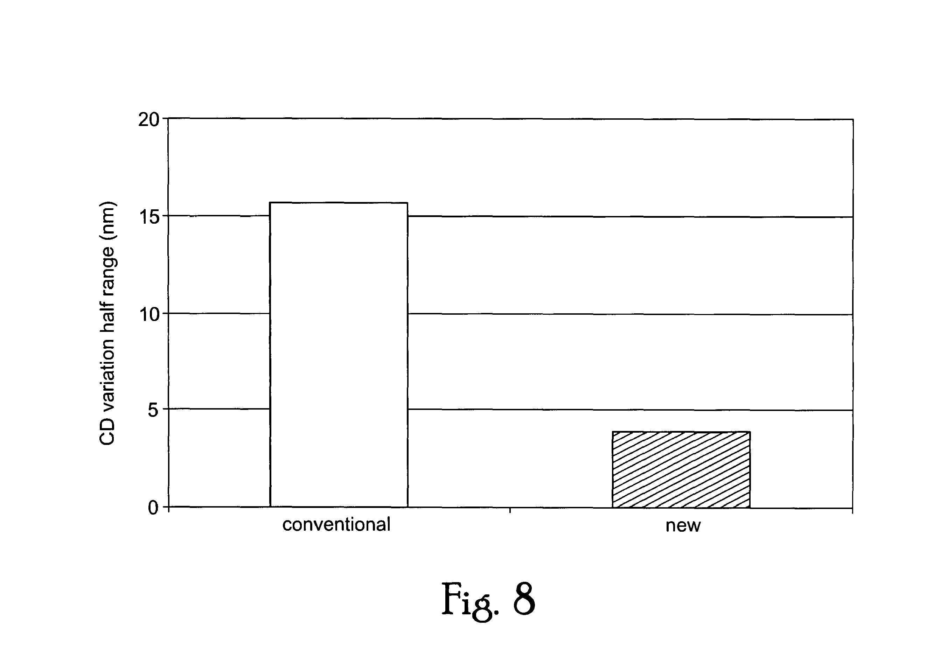

FIG. 8 shows the average simulated CD variation half range values for square arrays of 80 nm contact holes arranged in a 160 nm (minimum pitch), 200 nm, 240 nm, 280 nm and 320 nm pitch and obtained with a conventional optimization method (i.e. without a pupil filter having a central absorbing area) and with the method of the embodiment shown in FIG. 7, also referred to hereinafter as the "new" method. Calculations are performed with a 193 nm radiation wavelength, a 1.2 numerical aperture (immersion) and a minimum half pitch corresponding to $k_1 = 0.4$. A 6% attenuated phase shift mask is used for the conventional optimization method and a 100% high transmission phase shift mask is used to configure the transfer of the patterning device pattern according to the embodiment of FIG. 7 (the new method).

Preliminary calculations indicate that a conventional illumination shape (characterized by one sigma value, hereinafter also referred to as illumination shape - σ) is an appropriate candidate source shape to image the array of 80 nm contact holes. As such, a conventional illumination shape is used to carry out the imaging of the array of contact holes with both the conventional optimization method (i.e. without a pupil filter having a central absorbing area) and the new method. The sigma value of the conventional illumination shape is part of the optimization procedure for the conventional optimization method and the new method. It will be appreciated, however, that additional and/or different illumination configuration parameters could also be optimized in other embodiments of the invention. For example, if the initial candidate illumination configuration corresponds to a multipole illumination shape, the opening angle, the inner/outer diameter and the relative position of the poles could also be part of the optimization. Table 1 shows the various optimized values obtained with a simulation of the conventional method and the new method of FIG. 7.

Table 1

|  | dose (mJ / cm2) | bias range (nm) | sigma value | fractional pupil filter radius | CD variation half range (nm) |
|---|---|---|---|---|---|
| Conventional | 77.5 | -8 to -11 | 0.74 | not applicable | 15.7 |
| New method | 60.1 | 18 to 40 | 0.86 | 0.86 | 3.9 |

Calculations are done with PROLITH™ v8.1 using a calibrated photoresist model. An error budget including a 0.15 $\mu$m focus range, a 2% dose range and a 2 nm mask range is assumed.

The simulated results of FIG. 8 and Table 1 indicate that CD variation half range, which approximates the CDU, is much improved with the new method of FIG. 7 due to less focus and mask error sensitivity. It will be appreciated that the optimum fractional diameter of the pupil filter, i.e., the ratio of the diameter of an absorbing circular area of the pupil filter to the diameter of a clear aperture of the pupil, for this particular lithographic process substantially corresponds to twice the sigma value of the conventional illumination mode (zeroth non-diffracted order is blocked). Furthermore, the exposure dose range is much reduced, as compared to a conventional method.

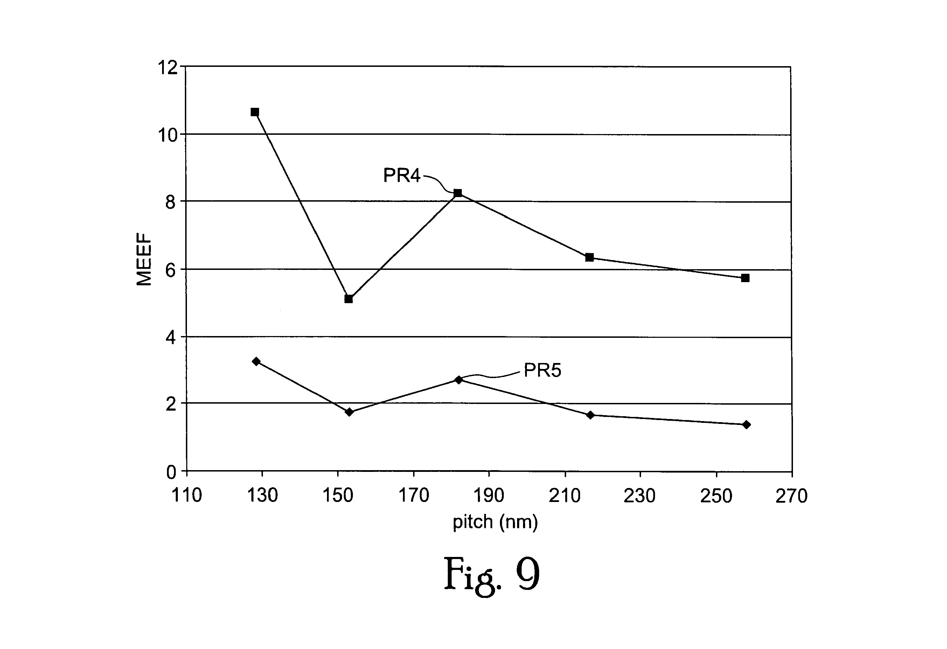

FIG. 9 shows the simulated MEEF as a function of pitch (in nm) for the process optimized with the conventional method (6% att-PSM and conventional illumination shape - σ = 0.74 and identified as graph "PR4" in FIG. 9) and the new method (chromeless PSM, conventional illumination shape - σ = 0.86 and pupil filter having a central absorbing area and identified as graph "PR5" in FIG. 9). As can be seen in FIG. 9, an imaging solution that combines an optimized pupil filter and a chromeless phase shift mask (CPL mask) provides much lower MEEF values through the entire 130 nm - 260 nm pitch range than a conventional imaging method. In FIG. 9, the diameter of the pupil filter is optimized to substantially reduce the zeroth non diffracted order.

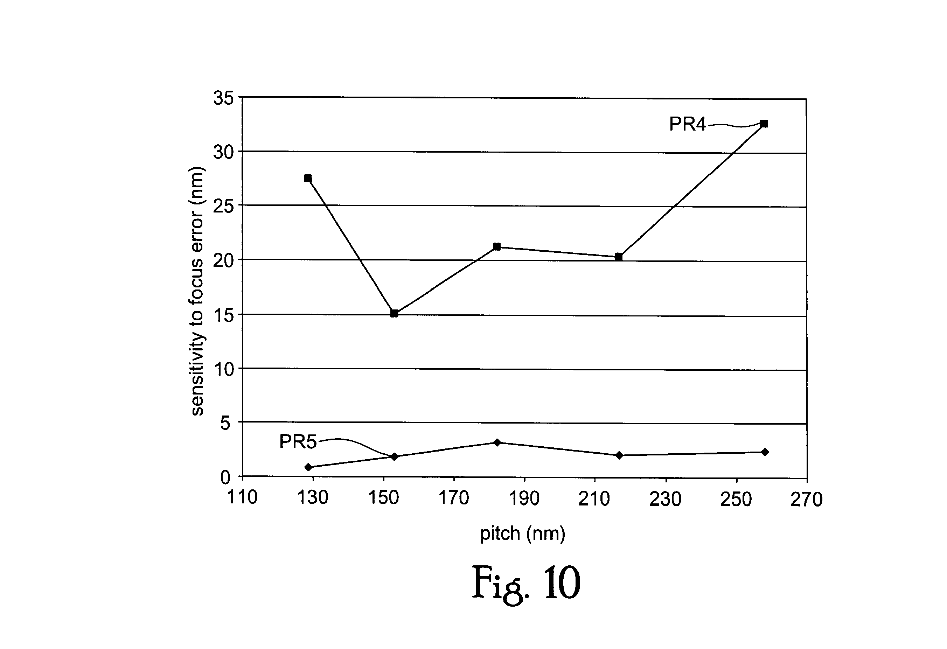

FIG. 10 shows the simulated variation of sensitivity of the contact holes to focus error as a function of pitch (in nm) for the process optimized with the conventional method (6% att-PSM and conventional illumination shape - σ = 0.74 and identified as graph "PR4" in FIG. 10) and the new method (chromeless PSM, conventional illumination shape - σ = 0.86 and pupil filter having a central absorbing area and identified as graph "PR5" in FIG. 10). A 0.15 $\mu$m focus range is assumed for this calculation. FIG. 10 shows that the contact holes are much less sensitive to error in focus for the process including a pupil filter and a chromeless phase shift mask through the entire pitch range than for the conventional imaging method. The CD variation of the contact holes due to focus error with a process including a pupil filter and a chromeless phase shift mask does not exceed four nanometers.

It will be appreciated that the method for configuring the pattern transfer on the substrate shown in FIG. 7 may be extended to any type of pattern. In an implementation, the method may be applied to optimize the transfer of a random or irregular pattern of features onto a substrate.

Imaging requirements for a random or irregular pattern of features, e.g., a pattern of contact holes, are generally more complex than for a regular pattern. In a random or irregular pattern of contact holes, the coordinates of a nearest neighbor contact hole of some contact holes may significantly vary, thus rendering the printing process difficult. FIG. 11 shows a schematic random or irregular pattern of 90 nm contact holes having a minimum pitch of about 171 nm, which corresponds to $k_1 = 0.4$ for a 193 nm radiation wavelength at 0.9NA. As can be seen in FIG. 11, the distance between a first contact hole and its nearest neighbor may be significantly larger than the distance between a second contact hole and its nearest neighbor. Furthermore, the relative orientation of a first pair of contact holes may be different from that of a second pair.

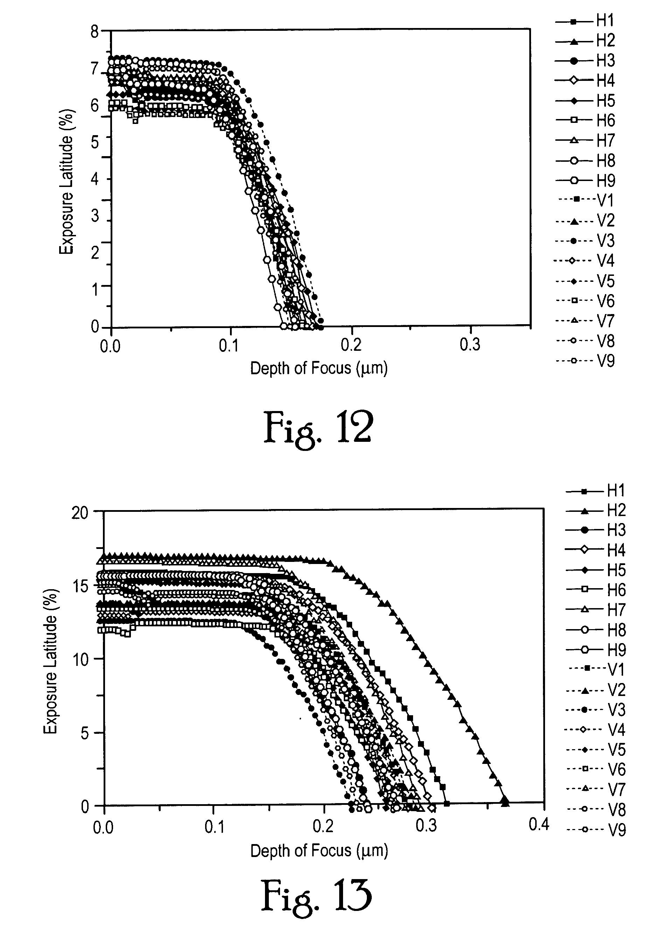

Referring to FIGS. 12 and 13, these figures show the simulated variations of exposure latitude (%) as a function of depth of focus for, respectively, a process optimized with a conventional method (no pupil filter included) and a process optimized in accordance with the new method (see the embodiment of FIG. 7). Calculations are done for the vertical ("V") and horizontal ("H") components of the nine contact holes (1-9) identified in FIG. 11. Calculations assume a numerical aperture of 0.9 and a 193 nm radiation wavelength. A 6% attenuated phase shift mask and a 0.7 conventional sigma illumination are used in FIG. 12 and a chromeless mask (CPL mask) and pupil filter is used in FIG. 13.

Preliminary simulations indicate that a conventional illumination mode is an appropriate illumination shape to optimize the pattern of FIG. 11. As such, a conventional illumination shape is used to carry out the imaging of the array of contact holes with both the conventional optimization method (i.e. without a pupil filter having a central absorbing area) and the new method. The fractional radius of the circular absorbing area of the pupil filter and the sigma value of the conventional illumination for the process optimized in accordance with the new method of FIG. 7 are set to about 0.7 and 0.5, respectively. This means that the fractional radius of the absorbing circular area of the pupil filter is larger than the fractional radius of the circular illumination intensity distribution in the illumination pupil. As such, the zeroth non-diffracted order is blocked. With such an arrangement, part of the first diffraction order is also blocked. The optimum mask biases for the two cases are 5 nm and a 20 nm respectively. In this embodiment, the mask bias is one of the parameters (see step 705) that is optimized in the procedure.

FIGS. 12 and 13 show that the exposure latitude and the depth of focus are much larger for the pupil filtering process of FIG. 13 (using the new method of FIG. 7) than for the conventional method of FIG. 12. MEEF values for the pattern of contact holes are in a range from about 6.5-7.7 for a conventional method and lower than 2.6 for a process optimized in accordance with the new method of FIG. 7. For reference, Table 2 shows the MEEF values for both the vertical and horizontal components of the nine holes of FIG. 11 for the process optimized in accordance with the new method FIG. 7.

Table 2

| Hole | MEEF |
|------|------|
| 1 H | 2.35 |
| 2H | 1.31 |
| 3H | 1.67 |
| 4H | 2.56 |
| 5H | 1.36 |
| 6H | 2.35 |
| 7H | 1.80 |
| 8H | 1.92 |
| 9H | 2.27 |
| 1 V | 1.60 |
| 2V | 1.76 |
| 3V | 1.39 |
| 4V | 1.53 |
| 5V | 2.88 |
| 6V | 2.51 |
| 7V | 1.69 |
| 8V | 1.85 |
| 9V | 1.59 |

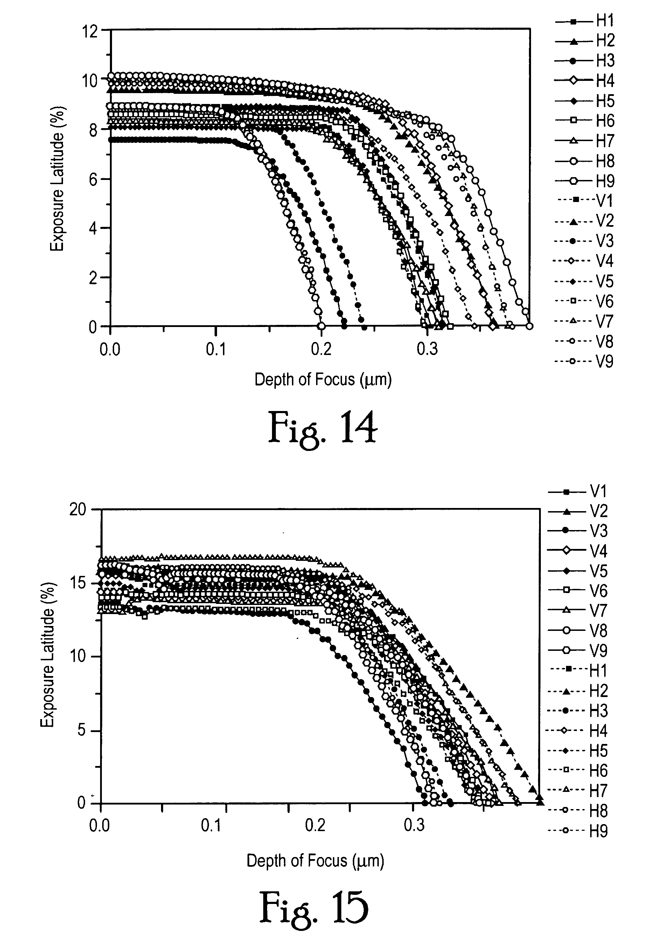

In an embodiment of the invention, a high transmission attenuated phase shift mask is used in conjunction with a pupil filter. This implementation provides satisfactory results in terms of depth of focus and MEEF without resorting to the use of complex illumination configurations. FIGS. 14 and 15 show respectively the simulated variation of exposure latitude as a function of depth of focus for an imaging solution (FIG. 14), including a bullseye illumination and a 50% attenuated phase shift mask (optimized with a conventional method), and another imaging solution (FIG. 15), including a conventional circular illumination, a 50% attenuated phase shift mask and a pupil filter (optimized with the new method). Results are given for the nine contact holes (1-9) identified in the random or irregular pattern of FIG. 11.

The bullseye illumination shape is shown in FIG. 16. This illumination includes a 0.32 central sigma pole and an annular component including an outer/inner sigma of about 1.3/1.1. The annular component corresponds to a dark field component, in reference to the fact that the zeroth non-diffracted order emanating from this illumination component is not collected by the projection system. For reference, FIG. 16 shows the outer limit corresponding to sigma = 1 (identified by "160"). In this embodiment, the ratio between the numerical aperture of the illumination system and the numerical aperture of the projection system ($NA_{PSOB}$) is selected such that the zeroth non-diffracted order obtained with the annular component is not collected by the projection system. In FIG. 16, the normalized radial position σ in the pupil plane of the illumination system of the annular component is between 1.1 and 1.3.

The conventional illumination, associated with the 50% attenuated phase shift mask and the pupil filter, is characterized by a central pole having a sigma of about 0.5.

Optimization of the transfer of the image of the random or irregular pattern of FIG. 11 in accordance with the new method of FIG. 7 provides a fractional radius of the absorbing area of the pupil filter of about 0.7. FIG. 15 indicates that the variation of exposure latitude as a function of depth of focus obtained with the imaging solution combining a pupil filter, a conventional illumination and a 50% attenuated phase shift mask, and optimized with the new method of FIG. 7, are similar to that obtained with a 100% transmission chromeless phase shift mask (see FIG. 13).

In addition, a comparison of FIGS. 14 and 15 shows that better results in terms of exposure latitude and depth of focus are obtained with the imaging solution combining a conventional circular illumination, a 50% attenuated phase shift mask and a pupil filter, and optimized with the new method of FIG. 7, than with the imaging solution using dark field illumination (bullseye illumination and 50% attenuated phase shift mask without pupil filtering).

It will also be appreciated that both imaging solutions of FIG. 15 (i.e. conventional circular illumination, 50% attenuated phase shift mask and pupil filter, and optimized with the new method of FIG. 7) and FIG. 14 (bullseye illumination of FIG. 16 and 50% attenuated phase shift mask) substantially improve the exposure latitude and the depth of focus as compared to the conventional imaging solution shown in FIG. 12. The conventional imaging solution of FIG. 12 combines a 6% attenuated phase shift mask and a 0.7 conventional sigma illumination. Thus, in both cases (i.e. imaging solutions of FIGS. 14 and 15), partial removal of the zeroth non-diffracted order is beneficial in printing contact holes. In the imaging solution of FIG. 15 (i.e., bullseye illumination of FIG. 16 and 50% attenuated phase shift mask), the zeroth non-diffracted order obtained with the annular illumination is not collected by the projection system. The finite numerical aperture of the projection system acts as a filter that only collects the zeroth order radiation obtained with the central pole of the bullseye illumination. In the imaging solution of FIG. 15 (i.e. conventional circular illumination, 50% attenuated phase shift mask and pupil filter, and optimized with the new method of FIG. 7), the zeroth order radiation is totally blocked by the pupil filter, thus improving the depth of focus and the exposure latitude.

It will be appreciated that the percentage of transmission may be one of the parameters that is optimized in the method of FIG. 7. FIG. 17(a) shows the simulated amplitude variation of various diffraction orders (00), (01), (11) and (00 pi) as a function of mask transmission (in %, "1" corresponding to 100%). As can be seen in FIG. 17(a) (by extrapolating the curve representing the zeroth order amplitude), the zeroth order changes phase (0 to pi) at about 25% transmission. As can also be seen in FIG. 17(a), the first and second diffraction order amplitudes slightly increase as the mask transmission increases. It will be appreciated that the amplitude of the second diffraction order remains substantially the same regardless of the mask transmission.

FIG. 17(b) shows the simulated variation of maximum intensity for a first pair of diffraction orders ((00) and (01)) and a second pair of diffraction orders ((01) and (11)) as a function of mask transmission (in %). As can be seen in FIG. 17(b), imaging with higher orders shows greater intensity than standard imaging with transmission greater than about 10%. FIG. 17(b) also shows that mask transmission percentages higher than about 10% provide satisfactory intensity. In an embodiment, the percentage of transmission is higher than about 10%.

It will be appreciated that the different acts involved in configuring the optical transfer of the pattern onto the substrate may be executed according to machine executable instructions. These machine executable instructions may be embedded in a data storage medium, *e.g.*, of a control unit of the lithographic apparatus. The control unit may include a processor that is configured to control the adjusting device AM and to modify the cross-sectional intensity distribution in the beam exiting the illumination system IL.

In an embodiment of the invention, the machine executable instructions may be embedded in a computer product which can be used in conjunction with a simulation software, such as Prolith™, Solid-C™, Lithocruiser™ or the like. That is, the computer product can be configured to generate and input illumination files into the simulation software and instruct the simulation software to calculate an image of the desired pattern using, for example, an aerial or a full resist simulation. The computer product may then be configured to output the calculated image and to evaluate this image versus one or more criteria to judge whether the image has appropriate optical qualities to successfully print the desired pattern on the substrate. The image can be analyzed, for example, through a focus range to provide estimates of the exposure latitude and depth of focus. The computer product may also be configured to create the contour maps for the different lithographic responses as a function of illumination point location.

Alternatively or additionally, the machine executable instructions may be part of a lithographic simulation software that provides the capability to calculate an image of the pattern.

Furthermore, although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion," respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (*e.g.*, having a wavelength of 365, 248, 193, 157 or 126 nm) and extreme ultra-violet (EUV) radiation (*e.g.*, having a wavelength in the range of 5-20 nm).

The term "patterning device" used herein should be broadly interpreted as referring to any device that can be used to impart a beam with a pattern in its cross-section such as to create a pattern in a target portion of the substrate. It should be noted that the pattern imparted to the beam may not exactly correspond to the desired pattern in the target portion of the substrate. Generally, the pattern imparted to the beam will correspond to a particular functional layer in a device being created in the target portion, such as an integrated circuit.

A patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned.

The support structure holds the patterning device in a way depending on the orientation of the patterning device, the design of the lithographic apparatus, and other conditions, such as for example whether or not the patterning device is held in a vacuum environment. The support can use mechanical clamping, vacuum, or other clamping techniques, for example electrostatic clamping under vacuum conditions. The support structure may be a frame or a table, for example, which may be fixed or movable as required and which may ensure that the patterning device is at a desired position, for example with respect to the projection system. Any use of the terms "reticle" or "mask" herein may be considered synonymous with the more general term "patterning device."

The term "projection system" used herein should be broadly interpreted as encompassing various types of projection systems, including refractive optical systems, reflective optical systems, and catadioptric optical systems, as appropriate for example for the exposure radiation being used, or for other factors such as the use of an immersion fluid or the use of a vacuum. Any use of the term "projection lens" herein may be considered as synonymous with the more general term "projection system."

The illumination system may also encompass various types of optical components, including refractive, reflective, and catadioptric optical components for directing, shaping, or controlling the beam of radiation, and such components may be referred to below, collectively or singularly, as a "lens."

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein a surface of the substrate is immersed in a liquid having a relatively high refractive index, e.g., water, so as to fill a space between a final element of the projection system and the substrate. Immersion liquids may also be applied to other spaces in the lithographic apparatus, for example, between the mask and a first element of the projection system. Immersion techniques are well known in the art for increasing the numerical aperture of projection systems.

The methods described herein may be implemented as software, hardware or a combination. In an embodiment, there is provided a computer program comprising a program code that, when executed on a computer system, instructs the computer system to perform any or all of the methods described herein.

While specific embodiments of the invention have been described above, it will be appreciated that the invention may be practiced otherwise than as described. The description is not intended to limit the invention.

## Claims

1. A method of transferring an image of a pattern from a patterning device onto a substrate with a lithographic apparatus, the method comprising:

   filtering a beam of radiation, patterned with the pattern of the patterning device, to substantially eliminate a zeroth non diffracted order from the image of the pattern transferred onto the substrate, the patterning device consisting of one of a chromeless phase shift mask and a high transmission attenuated phase shift mask having a percentage of transmission higher than about 10%; and

projecting the filtered patterned beam of radiation onto a substrate.

2.  The method of claim 1, further comprising capturing and projecting first and second diffraction orders of the patterned beam of radiation.

3.  The method of claim 1, wherein an apodization plate arranged in a projection system of the lithographic apparatus is used to substantially eliminate from the image the zeroth non diffracted order.

4.  The method of claim 1, further comprising adjusting a diameter of an area of a pupil filter, said area constructed and arranged to filter radiation of the beam of radiation.

5.  The method of claim 1, wherein the filtering includes filtering all the zeroth non diffracted orders.

6.  The method of claim 1, wherein a fractional radius of an area of a pupil filter that is constructed and constructed to filter radiation of the beam of radiation is larger than a fractional radius of the beam of radiation in a pupil plane of an illumination system of the lithographic apparatus.

7.  The method of claim 1, wherein said filtering includes adjusting a ratio between a numerical aperture of an illumination system that supplies said beam of radiation and a numerical aperture of a projection system that projects said patterned beam of radiation, said ratio being selected such that the zeroth non-diffracted order of said radiation beam is not collected in the image projected by said projection system.

8.  A method of configuring a transfer of an image of a pattern onto a substrate with a lithographic apparatus, the method comprising:

    selecting a plurality of parameters including a pupil filter parameter;
    calculating an image of the pattern for the selected parameters;
    calculating a metric that represents a variation of an attribute of the calculated image over a process range; and
    based on a result of the metric, iteratively (a) adjusting the pupil filter parameter, (b) calculating the image of the pattern and (c) calculating the metric until a substantially minimum or maximum value of variation of said attribute is obtained.

9.  The method of claim 8, wherein calculating an image of the pattern is executed using one model selected from the group of models consisting of a model wherein the image is modeled as an aerial image, a resist model and a calibrated model.

10. The method of claim 8 or claim 9, wherein the substantially minimum or maximum value is within a selected range of variation of the attribute.

11. The method of any one of claims 8 to 10, wherein a pupil filter is configured to substantially eliminate from the image a zeroth non diffracted order.

12. The method of any one of claims 8 to 11, wherein the attribute is CD variation, CD uniformity, MEEF, depth of focus, exposure latitude, or exposure dose to size.

13. The method of any one of claims 8 to 12, wherein calculating the metric includes calculating a metric that represents a variation of the attribute over a plurality of process ranges, and wherein the metric is a quadratic sum of CD variations that are each induced by one of the plurality of process ranges.

14. The method of claim 13, wherein the plurality of process ranges include a focus range, a mask error range and a exposure dose range.

15. The method of claim 13 or claim 14, wherein selecting, calculating the image, calculating the metric, and adjusting are done by computer simulation.

16. The method of any one of claims 8 to 15, wherein the pupil filter parameter includes a diameter of an area of the pupil filter, said area arranged and constructed to filter radiation of the beam of radiation.

**17.** The method of any one of claims 8 to 15, wherein the plurality of parameters include a source parameter and a patterning device parameter.

**18.** A lithographic apparatus, comprising:

an illumination system configured to condition a beam of radiation;
a support structure configured to hold a patterning device, the patterning device configured to pattern the beam of radiation to form a patterned beam of radiation and consisting of one of a chromeless phase shift mask and a high transmission attenuated phase shift mask having a percentage of transmission higher than about 10%;
a substrate table configured to hold a substrate;
an optical system configured to project the patterned beam of radiation onto the substrate; and
a filter arranged in a pupil plane of the projection system and configured to substantially eliminate a zeroth non-diffracted order of the patterned beam of radiation from the patterned beam at the substrate.

**19.** The apparatus of claim 18, wherein the optical system is configured to capture and project the first and second diffraction orders of the patterned beam of radiation.

**20.** The apparatus of claim 18, wherein the filter is an apodization plate.

**21.** A computer product having machine executable instructions, the instructions being executable by a machine to perform a method of configuring a transfer of an image of a pattern onto a substrate with a lithographic apparatus, the method comprising:

selecting a plurality of parameters including a pupil filter parameter;
calculating an image of the pattern for the selected parameters;
calculating a metric that represents a variation of an attribute of the calculated image over a process range; and
based on a result of the metric, iteratively (a) adjusting the pupil filter parameter, (b) calculating the image of the pattern and (c) calculating the metric until a substantially minimum or maximum value of variation of said attribute is obtained.

**22.** The computer product of claim 21, wherein the image of the pattern is calculated with an aerial image model, a resist model or a calibrated model

**23.** The computer product of claim 21 or claim 22, wherein the substantially minimum or maximum value is within a selected range of variation of the attribute.

**24.** The computer product of any one of claims 21 to 23, wherein a pupil filter is configured to substantially eliminate a zeroth non diffracted order from the image of the pattern transferred onto the substrate.

**25.** The computer product of any one of claims 21 to 24, wherein the attribute is CD variation, CD uniformity, MEEF, depth of focus, exposure latitude, or exposure dose to size.

**26.** The computer product of any one of claims 21 to 25, wherein calculating the metric includes calculating a metric that represents a variation of the attribute over a plurality of process ranges, and wherein the metric is a quadratic sum of CD variations that are each induced by one of the plurality of process ranges.

**27.** The computer product of claim 26, wherein the plurality of process ranges include a focus range, a mask error range and a exposure dose range.

**28.** The computer product of any one of claims 21 to 27, wherein the pupil filter parameter includes a diameter of an area of the pupil filter, said area constructed and arranged to filter radiation of the beam of radiation.

Fig. 1

Fig. 2(a)

Fig. 2(b)

Fig. 3(a)

Fig. 3(b)

Fig. 4(a)

Fig. 4(b)

Fig. 4(c)

Fig. 4(d)

Fig. 5(a)

Fig. 5(b)

Fig. 5(c)

Fig. 6

700 — Start

705 — Selecting a plurality of parameters including a pupil filter parameter

710 — Calculating an image of a pattern for the selected parameters

715 — Calculating a metric that represents variation of one attribute of the calculated image over an assumed range of focus, dose and patterning device error

720 — Is the metric result within an acceptable range of variation of the attribute and/or has converged to its optimal value?

No

Yes

725 — End

Fig. 7

EP 1 793 279 A2

Fig. 8

Fig. 9

Fig. 10

Fig. 11

Fig. 12

Fig. 13

Fig. 14

Fig. 15

Fig. 16

Fig. 17(a)

Fig. 17(b)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 36183103 A
- US 6839125 B
- US 71643903 A
- US 20040158808 A
- US 77339704 A
- US 20040156030 A